(19) Europäisches Patentamt
European Patent Office
Office européen des brevets

(11) **EP 1 734 804 B1**

(12) **EUROPÄISCHE PATENTSCHRIFT**

(45) Veröffentlichungstag und Bekanntmachung des Hinweises auf die Patenterteilung:
**07.05.2008 Patentblatt 2008/19**

(51) Int Cl.:
***H05K 13/08*** *(2006.01)*

(21) Anmeldenummer: **06115059.5**

(22) Anmeldetag: **07.06.2006**

(54) **Vorrichtung zum Handhaben von Bauteilen und zugehöriges Steuerverfahren**

Device for handling components and method of controlling

Dispositif de manutention de composants et procédé de commande

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **16.06.2005 DE 102005027900**

(43) Veröffentlichungstag der Anmeldung:
**20.12.2006 Patentblatt 2006/51**

(73) Patentinhaber: **SIEMENS AKTIENGESELLSCHAFT 80333 München (DE)**

(72) Erfinder: **Burger, Stefan 81379 München (DE)**

(56) Entgegenhaltungen:
**EP-A- 1 032 251          EP-A2- 0 845 934
WO-A-01/30124          WO-A-20/04084605**

EP 1 734 804 B1

**Beschreibung**

Die Erfindung betrifft eine Vorrichtung zum Handhaben von Bauteilen, insbesondere ein Bestückautomat zum Bestücken von Leiterplatten mit elektrischen Bauteilen, sowie ein zugehöriges Steuerverfahren.

In der Bestücktechnik werden Substrate bzw. Leiterplatten in einem Bestückautomaten mit elektrischen Bauteilen bestückt. Dabei kommt ein Bestückkopf des Bestückautomaten zum Einsatz, welcher mittels eines Positioniersystems in einer zu dem Substrat parallelen Ebene verfahrbar ist und zuvor aufgenommene elektrische Bauteile auf dem Substrat platziert. Der Bestückkopf verfügt dabei meist über eine oder mehrere Greifereinheiten zum Aufnehmen, Halten und Absetzen der Bauteile. Jede Greifereinheit umfasst meist einen Sauggreifer, dessen Spitze zum Halten der Bauteile mit Vakuum und zum Absetzen bzw. Abblasen der Bauteile mit Druckluft beaufschlagt werden kann. Dazu weist die Greiferspitze eine Saugöffnung auf, welche über eine pneumatische Leitung mit Druckluft bzw. einer Vakuumversorgung verbunden ist. In der Regel wird zum Abblasen der Bauteile bzw. zum Platzieren der Bauteile auf dem Substrat ein bestimmter Abblasdruck an der Saugöffnung des Sauggreifers eingestellt. Dabei kann insbesondere bei der Verwendung von sehr kleinen Bauteilen das Problem auftreten, dass die sich in der näheren Umgebung schon auf dem Substrat befindlichen Bauteile durch den Druckluftstoß verschoben oder gar weggeblasen werden.

Es ist deshalb die Aufgabe der vorliegenden Erfindung, eine Vorrichtung zum Handhaben von Bauteilen sowie ein zugehöriges Steuerverfahren mit einer erhöhten Prozesssicherheit zu liefern.

Diese Aufgabe wird durch eine Vorrichtung und ein Steuerverfahren gemäß den unabhängigen Ansprüchen gelöst. Vorteilhafte Ausgestaltungen sind jeweils Gegenstand der abhängigen Ansprüche.

Eine Vorrichtung zum Handhaben von Bauteilen, insbesondere ein Bestückautomat zum Bestücken von Leiterplatten mit elektrischen Bauteilen, gemäß Anspruch 1 weist mindestens eine Greifereinheit zum Aufnehmen, Halten und Abgeben der Bauteile auf. Jeder Greifereinheit ist jeweils ein Druckregelmodul zugeordnet. Das Druckregelmodul weist eine Vakuumpumpe mit einem Vakuumanschluss, einen mit dem Vakuumanschluss über eine Saugleitung pneumatisch verbundenen Sauganschluss, einen Drucksensor zur Erfassung des Drucks in der Saugleitung, einen Strömungssensor zur Erfassung des Gasdurchsatzes in der Saugleitung, ein steuerbares Ventil, über welches die Saugleitung mit einer externen Druckluftversorgung pneumatisch verbindbar ist, auf, wobei der Drucksensor, der Strömungssensor und das steuerbare Ventil über einen entsprechenden elektrischen Anschluss mit einer Regelelektronik verbindbar sind. Ferner weist jede Greifereinheit einen Sauggreifer mit einer Ansaugöffnung zum Halten der Bauteile auf. Die Ansaugöffnung des Sauggreifers ist dabei mit dem Sauganschluss des Druckregelmoduls, beispielsweise über eine Leitung, pneumatisch verbunden. Die Vorrichtung umfasst weiter eine Regelelektronik, welche mit dem Strömungssensor und dem steuerbaren Ventil verbunden und derart ausgestaltet ist, dass sie das Ventil in Abhängigkeit von dem durch den Strömungssensor gemessenen Gasdurchsatz in der Saugleitung steuert. Der Regelelektronik steht daher zur Steuerung des steuerbaren Ventils nicht nur der Wert des Drucks in der Saugleitung, sondern auch der Wert des Gasdurchsatzes in der Saugleitung zur Verfügung. Durch diesen zusätzlichen Parameter kann die Steuerung des steuerbaren Ventils besser an die jeweiligen Gegebenheiten und Anforderungen angepasst werden. Daher ist es möglich, den Abblasvorgang der Bauteile von der Sauggreiferspitze nicht nur in Abhängigkeit von dem an der Sauggreiferspitze herrschenden Druck, sondern auch von dem zur Sauggreiferspitze führenden Gasdurchsatz zu steuern. Dadurch kann erreicht werden, dass der Gasdurchsatz einen bestimmten Wert nicht überschreitet, wodurch beispielsweise ein Verblasen von Bauteilen auf dem Substrat verhindert werden kann. Dadurch wird die Prozess-Sicherheit deutlich erhöht.

Gemäß der Ausgestaltung nach Anspruch 2 ist das steuerbare Ventil als Piezoproportionalventil ausgebildet. Das Piezoproportionalventil ermöglicht sehr kurze Druck- und Vakuumaufbauzeiten in der Saugleitung des Druckregelmoduls. Dadurch kann die Ansaugöffnung des Sauggreifers sehr schnell mit Vakuum oder Druckluft beaufschlagt werden, wodurch die Bestückleistung spürbar gesteigert werden kann. Des Weiteren zeichnet sich das Piezoproportionalventil durch eine sehr hohe Zuverlässigkeit und eine sehr hohe Lastspielzahl aus.

In einer Ausgestaltung der Vorrichtung nach Anspruch 3 handelt es sich bei der Vakuumpumpe um eine StrömungsVakuumpumpe bzw. eine Venturidüse. Diese Art von Vakuumpumpe ermöglicht die Erzeugung eines kontinuierlichen Vakuums am Vakuumanschluss und zeichnet sich durch einen einfachen Aufbau, eine hohe Zuverlässigkeit, und eine geringe Anzahl beweglicher Teile auf.

In der Ausgestaltung gemäß Anspruch 4 kann das steuerbare Ventil von der Regelelektronik derart angesteuert werden, dass der Gasdurchsatz in der Saugleitung einen vorgegebenen Maximalwert, bei dem das Verblasen von auf dem Substrat befindlichen Bauteilen ausgeschlossen werden kann, nicht überschreitet. Diese einfache Steuerungsweise erlaubt den Einsatz eines kostengünstigen Schaltventils. Das Ventil wird von der Regelelektronik so lange geöffnet, bis der Wert einen Maximaldurchsatz erreicht und wird anschließend geschlossen.

Bei einer weiterführenden Ausgestaltung der Vorrichtung nach Anspruch 5 ist die Regelelektronik in einem Durchsatz-Regelmodus betreibbar, bei dem der Gasdurchsatz in der Saugleitung auf einen vorgegebenen Durchsatz-Sollwert eingeregelt wird. Im Unterschied zur vorhergehenden Ausgestaltung gemäß Anspruch 4 wird das steuerbare Ventil von der Regelelektronik nicht nur bis zum Erreichen eines Maximaldurchsatzes geöffnet, sondern exakt so eingeregelt, dass der Gasdurchsatz über einen vorgegebenen Zeitraum exakt einem Durchsatz-Sollwert entspricht. Dadurch kann erhöhten Ansprüchen beim Abblasen der Bauteile entsprochen werden.

Die Vorrichtung kann gemäß Anspruch 6 auch dahingehend ausgestaltet werden, dass die Regelelektronik zusätzlich mit dem Drucksensor verbunden ist. Dies ermöglicht, dass die Regelelektronik in einem Druck-Regelmodus den in der Saugleitung herrschenden Druck in Abhängigkeit vom Gasdurchsatz in der Saugleitung regelt. Dies kann beispielsweise so geschehen, dass die Regelelektronik durch Ansteuern des steuerbaren Ventils den Druck in der Saugleitung auf einen Wert einstellt, bei dem der Gasdurchsatz einen bestimmten Wert erreicht. Durch diese doppelte Abhängigkeit der Steuerung des steuerbaren Ventils durch die Regelelektronik kann gleichzeitig sichergestellt werden, dass ein maximaler Druck und ein maximaler Gasdurchsatz in der Saugleitung nicht überschritten werden. Beides trägt zu einer erhöhten Prozess-Sicherheit bei.

In der Vorrichtung gemäß Anspruch 7 kann die Regelelektronik das von dem Strömungssensor gelieferte Signal auch zur Bestimmung der Anwesenheit von Bauteilen an der Ansaugspritze verwendet werden. Bei Unterschreiten eines bestimmten Wertes für den Gasdurchsatz in der Saugleitung erkennt die Regelelektronik, dass ein Bauteil an der Greifereinheit bzw. am Sauggreifer angesaugt ist. Dies ermöglicht eine sehr schnelle Statusbestimmung bzw. eine Anwesenheitskontrolle von Bauteilen am Sauggreifer. Auch dies trägt zu einer erhöhten Prozess-Sicherheit bei.

In der Ausgestaltung gemäß Anspruch 8 kann die Regelelektronik zwischen dem in Anspruch 5 beschriebenen Durchsatz-Regelmodus und dem in Anspruch 6 beschriebenen Druck-Regelmodus wahlweise umschalten. Die erlaubt eine flexible Anpassung der Regelung an die jeweiligen Bedürfnisse.

Bei einem Steuerverfahren gemäß Anspruch 9 für eine erfindungsgemäße Vorrichtung steuert die Regelelektronik beim Abblasen eines an der Greifereinheit angesaugten Bauteiles das steuerbare Ventil derart an, dass der Gasdurchsatz in der Saugleitung einen Maximaldurchsatz nicht überschreitet. Dadurch kann das Verblasen von Bauteilen, welche sich schon auf dem Substrat befinden, verhindert werden.

In einer Ausgestaltung des Steuerverfahrens nach Anspruch 10 wird die Regelelektronik beim Abblasen des Bauteils in dem in Anspruch 5 beschriebenen Durchsatz-Regelmodus betrieben.

Das Steuerverfahren kann gemäß Anspruch 11 auch dahingehend ausgestaltet werden, dass die Regelelektronik beim Abblasen des Bauteils in einem Druck-Regelmodus betrieben wird und dabei den Druck in der Saugleitung auf einen Drucksollwert regelt, bei dem der Gasdurchsatz in der Saugleitung den Maximaldurchsatz nicht überschreitet.

Bei dem Steuerverfahren gemäß Anspruch 12 kann die Regelelektronik nach dem Abblasen des Bauteils im Druck-Regelmodus betrieben werden, um ein nächstes Bauteil anzusaugen, wobei der Druck in der Saugleitung auf einen vorgegebenen Unterdruck-Sollwert eingeregelt wird.

Im Folgenden werden Ausführungsbeispiele der erfindungsgemäßen Vorrichtung zum Handhaben von Bauteilen und dem Steuerverfahren mit Bezug auf die beigefügten Zeichnungen näher erläutert. In den Figuren sind

Figur 1 eine schematische Darstellung eines Bestückautomaten zum Bestücken von Substraten mit elektrischen Bauteilen,

Figur 2 eine schematische Teildarstellung eines Bestückkopfes, wie er bei dem in Figur 1 dargestellten Bestückautomaten eingesetzt werden kann,

Figur 3 eine schematische Darstellung eines Ausführungsbeispiels eines Druckregelmoduls, wie es in den Greifereinheiten des in Figur 2 dargestellten Bestückkopfes zum Einsatz kommt.

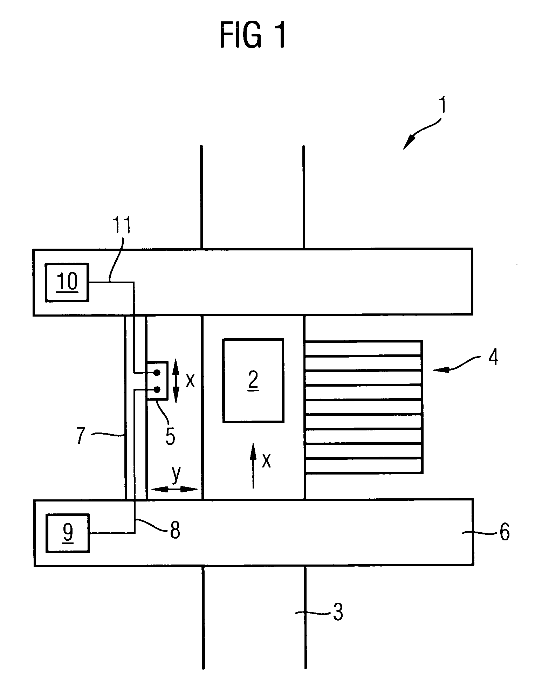

In Figur 1 ist ein Ausführungsbeispiel einer erfindungsgemäßen Vorrichtung zum Handhaben von Bauteilen bzw. ein Bestückautomat 1 zum Bestücken von Leiterplatten 2 mit elektrischen Bauteilen schematisch dargestellt. Zu bestückende Leiterplatten 2 werden entlang einer Transportstrecke 3 in einer Transportrichtung (Pfeil x) zu einem Bestückplatz transportiert, dort bestückt und weiter transportiert. Seitlich der Transportstrecke 3 befinden sich in einem Zuführbereich Zuführeinrichtungen 4, welche die elektrischen Bauteile bereitstellen. Ein Bestückkopf 5 ist mittels eines Positioniersystems zwischen den Zuführeinrichtungen 4 und dem Bestückplatz verfahrbar angeordnet. Das Positioniersystem besteht dabei aus zwei portalartigen Querträgern 6, welche sich brückenartig quer über die Transportstrecke 3 erstrecken, sowie einem Längsträger 7, welcher an seinen Enden verschieblich an den Querträgern 6 gelagert und beispielsweise mittels eines Linearmotors quer zur Transportrichtung (Pfeil y) verfahrbar ist. Am Längsträger 7 ist der Bestückkopf 5 beispielsweise mittels eines weiteren Linearmotors parallel zur Transportrichtung (Pfeil x) bewegbar gelagert.

Der Bestückkopf 5 ist über pneumatische Leitungen 8 mit einer Druckluftversorgung 9 verbunden, welche an einem geeigneten Ort am Bestückautomaten 1 angeordnet ist. Eine Regelelektronik 10 für den Bestückkopf 5 ist ebenfalls am Bestückautomaten 1 vorgesehen und über entsprechende elektrische Leitungen 11 mit dem Bestückkopf 5 verbunden.

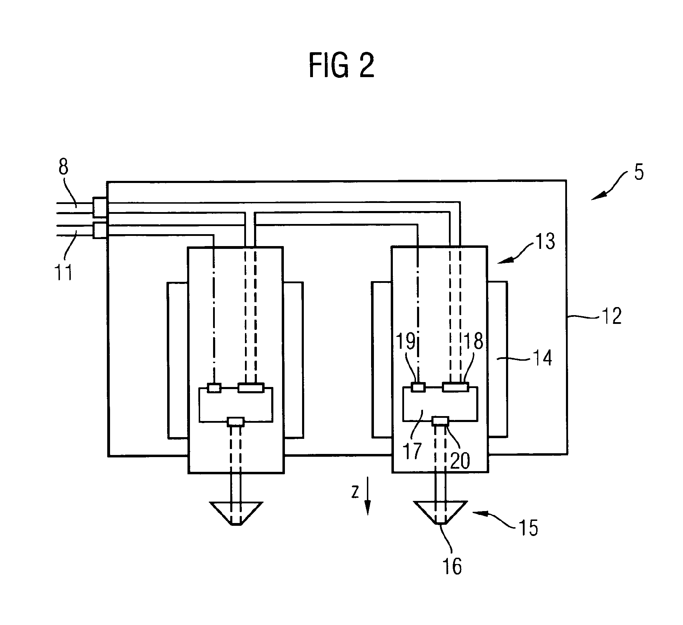

In Figur 2 ist ein Ausschnitt des Bestückkopfes aus Figur 1 schematisch dargestellt. Zur besseren Übersichtlichkeit sind nur die für die Erfindung wesentlichen Teile des Bestückkopfes dargestellt. In einem Gehäuse 12 des Bestückkopfes sind mehrere Greifereinheiten 13 nebeneinander angeordnet. Die Greifereinheiten 13 sind jeweils mittels eines Linearantriebs 14 in einer Richtung senkrecht zur Bestückebene (Pfeil z) relativ zum Gehäuse 12 des Bestückkopfes verfahrbar. Die Greifereinheiten 13 weisen jeweils an ihrer Unterseite einen Sauggreifer 15 mit einer Ansaugöffnung 16 auf, mit dem Bauteile durch Ansaugen aufgenommen und gehalten werden können. Innerhalb jeder Greifereinheit 13 ist ein (in Figur 2 als Block dargestelltes) Druckregelmodul 17 angeordnet. Jedes Druckregelmodul 17 weist einen Druckluftanschluss 18 auf, welcher mit der von der Druckluftversorgung 9 zum Bestückkopf 5 führenden pneumatischen Leitung 8 verbunden ist. Ferner ist das Druckregelmodul 17 mittels einer Steckerverbindung 19 über die elektrische Leitungen 11 mit der Regelelektronik 10 des Bestückautomaten 1 verbunden. Das Druckregelmodul 17 weist an seiner Unterseite einen Sauganschluss 20 auf, welcher mit der Ansaugöffnung 16 des Sauggreifers über eine weitere pneumatische Leitung verbunden ist. Die Verbindung des Sauggreifers mit dem Druckregelmodul 17 kann dabei über eine einfache Steckverbindung realisiert werden.

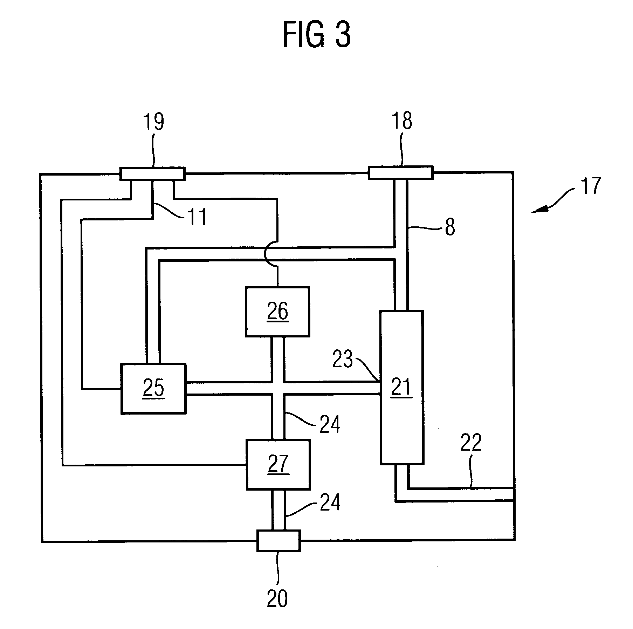

Anhand von Figur 3 werden der Aufbau und die Funktionsweise des Druckregelmoduls 17 näher beschrieben. Das Druckregelmodul 17 umfasst eine Vakuumpumpe 21, welche im Ausführungsbeispiel als eine Strömungsvakuumpumpe bzw. eine Venturidüse realisiert ist. Die Venturidüse wird über den Druckluftanschluss 18 des Druckregelmoduls 17, welcher wiederum mit der Druckluftversorgung 9 des Bestückautomaten 1 verbunden ist, mit Druckluft versorgt, wobei die Abluft der Venturidüse über einen Abluftkanal 22 entsorgt wird. Ein Vakuumanschluss 23 der Venturidüse ist über eine Saugleitung 24 mit dem Sauganschluss 20 des Druckregelmoduls 17 pneumatisch verbunden, an dem wiederum der Sauggreifer 15 der Greifereinheit 13 angeschlossen ist (siehe Figur 2). Das Druckregelmodul 17 weist ferner ein steuerbares Ventil 25 auf, über welches die Saugleitung 24 mit dem Druckluftanschluss 18 bzw. mit der Druckluftversorgung 9 des Bestückautomaten 1 wahlweise verbunden oder von dieser getrennt werden kann. Bei dem Druckregelmodul 17 handelt es sich vorteilhafterweise um ein Piezo-Proportional-Ventil 25, welches sich durch eine hohe Zuverlässigkeit und eine sehr schnelle und genaue Regelung auszeichnet.

Das Druckregelmodul 17 weist ferner einen Drucksensor 26 zum Erfassen des Drucks in der Saugleitung 24 sowie einen Strömungssensor 27 zum Erfassen des Gasdurchsatzes in der Saugleitung 24 auf. Das steuerbare Ventil 25, der Drucksensor 26 und der Strömungssensor 27 sind mittels einer Steckerverbindung 19 des Druckregelmoduls 17 über elektrische Leitungen 11 mit der Regelelektronik 10 des Bestückautomaten 1 verbunden.

Wie aus der obigen Beschreibung des Aufbaus des Druckregelmoduls 17 hervorgeht, bewirkt die Vakuum-Pumpe bei geschlossenem Ventil 25 in der Saugleitung 24 einen Unterdruck, welcher mit wachsendem Öffnungsgrad des steuerbaren Ventils 25 zunehmend überblasen wird. Ab einem bestimmten Öffnungsgrad des Ventils 25 herrscht Überdruck in der Saugleitung 24. Durch eine entsprechende Ansteuerung des steuerbaren Ventils 25 kann der Druck in der Saugleitung 24 stufenlos zwischen den beiden Extrempositionen eingestellt werden.

Zum Aufnehmen und Halten von Bauteilen wird die Ansaugöffnung 16 des Sauggreifers mit Vakuum beaufschlagt, weshalb die Regelelektronik 10 das steuerbare Ventil 25 derart ansteuert, dass sich in der Saugleitung 24 bzw. am Sauganschluss 20 des Druckregelmoduls 17 ein bestimmter Unterdruck-Sollwert einstellt. Durch die Verwendung eines Piezo-Proportional-Ventils 25 ist dies sehr schnell und zuverlässig möglich. Beim Bestücken werden die Bauteile von der Ansaugöffnung 16 des Sauggreifers abgeblasen, was durch Überblasen des in der Saugleitung 24 bzw. am Sauganschluss 20 von der Vakuumpumpe 21 erzeugten Vakuums durch Öffnen des steuerbaren Ventils 25 geschieht. Durch Öffnen des steuerbaren Ventils 25 wird die Saugleitung 24 nämlich mit der Druckluftversorgung 9 des Bestückautomaten 1 verbunden, wobei der Druck in der Saugleitung 24 und damit an der Ansaugöffnung 16 des Sauggreifers je nach Öffnungsgrad des steuerbaren Ventils 25 ansteigt.

Zum sicheren Aufnehmen und Halten bzw. zum Abblasen der Bauteile ist eine Regelung der Druck- bzw. der Strömungsverhältnisse in der Saugleitung 24 des Druckregelmoduls 17 erforderlich. Der Regelelektronik 10 stehen durch das Druckregelmodul 17 dazu die Signale des Drucksensors 26 und des Strömungssensors 27 zur Verfügung. Dadurch ergeben sich für die Regelung zusätzliche Möglichkeiten, welche im Folgenden näher erläutert werden.

In einem Durchsatz-Regelmodus der Regelelektronik 10 regelt die Regelelektronik 10 den durch den Strömungssensor 27 gemessenen Gasdurchsatz in der Saugleitung 24 durch entsprechende Ansteuerung des steuerbaren Ventils 25 beim Abblasen der Bauteile auf einen vorgegebenen Durchsatz-Sollwert ein. Der Durchsatz-Sollwert kann je nach Art der verwendeten Bauteile in der Regelelektronik 10 variiert werden. Der Durchsatz-Sollwert wird dabei so eingestellt, dass in der Saugleitung 24 ein Maximal-Gasdurchsatz nicht überschritten wird. Der Maximal-Gasdurchsatz ist dabei so gewählt, dass auf dem Substrat befindliche Bauteile in der Umgebung des Sauggreifers beim Abblasen des Bauteils von dem Sauggreifer 15 nicht weggeblasen werden. Bei dem Durchsatz-Regelmodus liegt demnach ein geschlossener Regelkreis vor, wobei der Gasdurchsatz in der Saugleitung 24 die Regelgröße und der Öffnungsgrad des steuerbaren Ventils 25 die Stellgröße darstellen. Im Durchsatz-Regelmodus wird das Signal des Drucksensors 26 von der Regelelektronik 10 nicht berücksichtigt.

Die Regelelektronik 10 ist wahlweise auch in einem Druck-Regelmodus betreibbar. Im Unterschied zum Durchsatz-Regelmodus regelt die Regelelektronik 10 im Druck-Regelmodus den in der Saugleitung 24 herrschenden Druck in Abhängigkeit vom Gasdurchsatz in der Saugleitung 24. Auch hierbei handelt es sich um einen geschlossenen Regelkreis, wobei es sich bei der Regelgröße um den Druck in der Saugleitung 24 und bei der Stellgröße um den Öffnungsgrad des steuerbaren Ventils 25 handelt. Im Druck-Regelmodus berücksichtigt die Regelelektronik 10 sowohl das Signal des Drucksensors 26 als auch das Signal des Strömungssensors 27. Ein von der Regelelektronik 10 durch entsprechendes Ansteuern des steuerbaren Ventils 25 einzustellender Druck-Sollwert kann dabei in Abhängigkeit von dem durch den Strömungssensor 27 gemessenen Gasdurchsatz in der Saugleitung 24 verändert werden. Dies kann beispielsweise nach folgender Formel geschehen:

$$P_{soll} = P_{Min} - f \times \dot{V}$$

Wie aus der obigen Gleichung hervorgeht, ergibt sich der in der Saugleitung 24 einzuriegelnde Druck-Sollwert $P_{soll}$ durch die Differenz aus einem Mindestabblasdruck $P_{Min}$ und dem mit einem Faktor f gewichteten Gasdurchsatz $\dot{V}$. Der Mindestabblasdruck $P_{Min}$ ist der Druck, der in der Gasleitung einzustellen ist, wenn das Bauteil noch an der Ansaugöffnung 16 des Sauggreifers anhaftet und der gemessene Gasdurchsatz $\dot{V}$ deshalb nahezu Null ist. Der Mindestabblasdruck $P_{Min}$ kann dabei je nach Bauteil variieren. Der Faktor f dient der Umrechnung des vom Strömungssensor 27 gemessenen Gasdurchsatzes $\dot{V}$ in einen entsprechenden Druck in der Saugleitung 24. Die Regelelektronik 10 verändert den Druck-Sollwert $P_{soll}$ also in Abhängigkeit vom Gasdurchsatz $\dot{V}$ in der Saugleitung 24 derart, dass der Druck-Sollwert $P_{soll}$ bei steigendem Gasdurchsatz $\dot{V}$ abnimmt. Sobald sich beim Abblasen des Bauteiles das Bauteil von der Ansaugöffnung 16 des Sauggreifers löst, erhöht sich der Gasdurchsatz in der Saugleitung 24. Dies wird vom Strömungssensor 27 erfasst, wodurch sich der Wert für den Druck-Sollwert $P_{soll}$ immer weiter vermindert. Dadurch wird verhindert, dass im Fall, dass kein Bauteil mehr an der Ansaugspitze des Sauggreifers vorhanden ist, die Regelelektronik 10 durch immer weiteres Öffnen des steuerbaren Ventils 25 versucht, einen konstanten Abblasdruck in der Saugleitung 24 aufrecht zu erhalten. In dem Fall würde es nämlich zu derart hohen Gasdurchsätzen in der Saugleitung 24 kommen, dass Bauteile, die sich in der Nähe des Sauggreifers auf dem Substrat befinden, weggeblasen werden. Durch die Einbeziehung des Signals des Strömungssensors 27 in die Regelung des Drucks in der Saugleitung 24 wird dadurch die Prozess-Sicherheit deutlich erhöht.

Unabhängig vom Regelmodus kann das Signal des Strömungssensors 27 auch zur Anwesenheitserkennung eines Bauteiles an der Ansaugöffnung 16 des Sauggreifers verwendet werden. Dies ist beispielsweise dadurch möglich, dass falls vom Drucksensor 26 ein Unterdruck und gleichzeitig vom Strömungssensor 27 ein sehr geringer Wert für den Gasdurchsatz in der Saugleitung 24 erfasst werden, die Regelelektronik 10 die Anwesenheit eines Bauteiles am Sauggreifer 15 erkennt. Diese Methode zur Erkennung von Bauteilen am Sauggreifer 15 ist sehr schnell und zuverlässig.

Auch wenn in dem oben beschriebenen Ausführungsbeispiel ein Piezo-Proportionalventil eingesetzt wird, so ist auch die Verwendung eines einfachen Schaltventils möglich. In diesem Fall wäre es beim Abblasen von Bauteilen möglich, das Schaltventil solange zu öffnen, bis ein Maximal-Gasdurchsatz in der Saugleitung 24 überschritten wird und das Schaltventil anschließend zu schließen.

Bezugszeichenliste:

| | |
|---|---|
| 1 | Bestückautomat |
| 2 | Leiterplatte |
| 3 | Transportstrecke |
| 4 | Zuführeinrichtung |
| 5 | Bestückkopf |
| 6 | Querträger |
| 7 | Längsträger |
| 8 | Pneumatische Leitung |
| 9 | Druckluftversorgung |
| 10 | Regelelektronik |
| 11 | Elektrische Leitung |
| 12 | Gehäuse |
| 13 | Greifereinheit |
| 14 | Linearantrieb |
| 15 | Sauggreifer |
| 16 | Ansaugöffnung |
| 17 | Druckregelmodul |
| 18 | Druckluftanschluss |

19 Steckerverbindung

20 Sauganschluss

21 Vakuumpumpe

22 Abluftkanal

23 Vakuumanschluss

24 Saugleitung

25 Steuerbares Ventil

26 Drucksensor

27 Strömungssensor

**Patentansprüche**

1. Vorrichtung zum Handhaben von Bauteilen, insbesondere Bestückautomat (1) zum Bestücken von Leiterplatten (2) mit elektrischen Bauteilen, mit

   - mindestens einer Greifereinheit (13), welche ein Druckregelmodul (17), bestehend aus

     - einer Vakuumpumpe (21), die einen Vakuumanschluss (23) aufweist,
     - einem Sauganschluss (20), der mit dem Vakuumanschluss (23) über eine Saugleitung (24) pneumatisch verbunden ist,
     - einem Drucksensor (26) zum Erfassen des Drucks in der Saugleitung (24),
     - einem Strömungssensor (27) zum Erfassen eines Gasdurchsatzes in der Saugleitung (24),
     - einem steuerbaren Ventil (25), über das die Saugleitung (24) mit einer Druckluftversorgung (9) pneumatisch verbindbar ist,
     - wobei der Drucksensor (26), der Strömungssensor (27) und das steuerbare Ventil (25) mit einer Regelelektronik (10) verbindbar sind,

     und einen Sauggreifer (15) zum Halten der Bauteile aufweist, wobei eine Ansaugöffnung (16) des Sauggreifers mit dem Sauganschluss (20) des Druckregelmoduls (17) pneumatisch verbunden ist, und
   - einer Regelelektronik (10), die mit dem Strömungssensor (27) und dem steuerbaren Ventil (25) verbunden ist, um das Ventil (25) in Abhängigkeit vom Gasdurchsatz in der Saugleitung (24) zu steuern.

2. Vorrichtung nach Anspruch 1, wobei es sich bei dem steuerbaren Ventil (25) um ein Piezo-Proportionalventil handelt.

3. Vorrichtung nach einem der Ansprüche 1 bis 2, wobei die Vakuumpumpe (21) eine Strömungsvakuumpumpe ist.

4. Vorrichtung nach einem der Ansprüche 1 bis 3, wobei das steuerbare Ventil (25) von der Regelelektronik (10) derart steuerbar ist, dass der Gasdurchsatz in der Saugleitung (24) einen Maximal-Durchsatz nicht überschreitet.

5. Vorrichtung nach einem der Ansprüche 1 bis 4, wobei die Regelelektronik (10) in einem Durchsatz-Regelmodus den Gasdurchsatz in der Saugleitung (24) auf einen Durchsatz-Sollwert regelt.

6. Vorrichtung nach einem der Ansprüche 1 bis 5, wobei die Regelelektronik (10) mit dem Drucksensor (26) verbunden ist, sodass die Regelelektronik (10) in einem Druck-Regelmodus den in der Saugleitung (24) herrschenden Druck in Abhängigkeit vom Gasdurchsatz in der Saugleitung (24) regelt.

7. Vorrichtung nach einem der Ansprüche 1 bis 6, wobei die Regelelektronik (10) bei Unterschreiten eines bestimmten Werts für den Gasdurchsatz in der Saugleitung (24) erkennt, dass ein Bauteil an der Greifereinheit (13) angesaugt ist.

8. Vorrichtung nach Anspruch 6, wobei die Regelelektronik (10) zwischen dem Durchsatz-Regelmodus und dem Druck-Regelmodus wahlweise umschaltbar ist.

9. Steuerverfahren für eine Vorrichtung nach einem der Ansprüche 1 bis 3, wobei die Regelelektronik (10) beim Abblasen eines an der Greifereinheit (13) angesaugten Bauteils das steuerbare Ventil (25) so ansteuert, dass der Gasdurchsatz in der Saugleitung (24) einen Maximal-Durchsatz nicht überschreitet.

10. Steuerverfahren nach Anspruch 9, wobei die Regelelektronik (10) beim Abblasen des Bauteils in einem Durchsatz-Regelmodus betrieben wird und den Gasdurchsatz in der Saugleitung (24) auf einen vorgegebenen Durchsatz-Sollwert regelt.

11. Steuerverfahren nach Anspruch 9, wobei die Regelelektronik (10) beim Abblasen des Bauteils in einem Druck-Regelmodus betrieben wird, und den Druck in der Saugleitung (24) auf einen Druck-Sollwert regelt, bei dem der Gasdurchsatz in der Saugleitung (24) den Maximal-Durchsatz nicht übersteigt.

12. Steuerverfahren nach Anspruch 10, wobei nach dem Abblasen des Bauteils die Regelelektronik (10) zum Ansaugen eines weiteren Bauteils in einem Druck-Regelmodus betrieben wird und den Druck in der Saugleitung (24) auf einen vorgegebenen Unterdruck-Sollwert regelt.

## Claims

1. Device for handling components, especially automatic component mounting device (1) for equipping printed circuit boards (2) with electrical components, with

   - at least one gripper unit (13), which features a pressure regulation module (17), consisting of

      - a vacuum pump (21), which features a vacuum connection (23),
      - a suction connection (20), which is pneumatically connected to the vacuum connection (23) via a suction line (24),
      - a pressure sensor (26) for detecting the pressure in the suction line (24),
      - a flow sensor (27) for detecting a gas throughflow in the suction line (24),
      - a controllable valve (25), via which the suction line (24) is pneumatically connected to a compressed air supply (9),
      - with the pressure sensor (26), the flow sensor (27) and the controllable valve (25) able to be connected to regulation electronics (10),

   and features a suction gripper (15) to hold the components, with a suction opening (16) of the suction gripper being pneumatically connected to the suction connection (20) of the pressure regulation module (17), and
   - regulation electronics(10), which is connected to the flow sensor (27) and the controllable valve (25) in order to control the valve (25) as a function of the gas throughflow in the suction line (24).

2. Device in accordance with claim 1, in which the controllable valve (25) is a piezo-proportional valve.

3. Device in accordance with one of the claims 1 to 2, in which the vacuum pump (21) is a flow vacuum pump.

4. Device in accordance with one of the claims 1 to 3, with the controllable valve (25) being able to be controlled by the regulation electronics (10) such that the throughflow of gas in the suction line (24) does not exceed a maximum throughflow.

5. Device in accordance with one of the claims 1 to 4, with the regulation electronics (10) in a throughflow control mode regulating the gas throughflow in the suction line (24) to a setpoint throughflow value.

6. Device in accordance with one of the claims 1 to 5, with the regulation electronics (10) being connected to the pressure sensor (26) so that the regulation electronics (10) in a pressure regulation mode regulates the pressure obtaining in the suction line (24) as a function of the gas throughflow in the suction line (24).

7. Device in accordance with one of the claims 1 to 6, with the regulation electronics (10) detecting, when a specific value for the gas throughflow in the suction line (24) is undershot, that a component is being sucked up by the gripper unit (13).

8. Device in accordance with claim 6, with the regulation electronics (10) being able to be switched as required between the throughflow regulation mode and the pressure regulation mode.

9. Method of controlling a device in accordance with one of the claims 1 to 3, with the regulation electronics (10) activating the controllable valve (25) on release of a component sucked onto the gripper unit (13) so that the gas throughflow in the suction line (24) does not exceed a maximum throughflow.

10. Control method according to claim 9, with the regulation electronics (10) being operated in a throughflow regulation mode on release of the component and regulating the gas throughflow in the suction line (24) to a predetermined setpoint throughflow value.

11. Control method according to claim 9, with the regulation electronics (10) being operated in a pressure regulation mode on release of the component and regulating the pressure in the suction line (24) to a predetermined setpoint pressure value in which gas throughflow in the suction line (24) does not exceed the maximum throughflow.

12. Control method according to claim 10, with the regulation electronics (10), after the release of the component, being operated in a pressure regulation mode for sucking up a further component and regulating the pressure in the suction line (24) to a predetermined setpoint low pressure value.

## Revendications

1. Dispositif de manutention de composants, en particulier automate d'équipement (1) pour l'équipement de plaques de circuits imprimés (2) avec des composants électriques, comprenant

- au moins une unité de prise (13), qui présente un module de réglage de pression (17), comportant

- une pompe à vide (21), qui présente un branchement de vide (23),
- un branchement d'aspiration (20), qui est relié de façon pneumatique au branchement de vide (23) par une conduite d'aspiration (24),
- un capteur de pression (26) pour l'enregistrement de la pression dans la conduite d'aspiration (24),
- un capteur d'écoulement (27) pour l'enregistrement d'un débit de gaz dans la conduite d'aspiration (24),
- une vanne commandable (25), par laquelle la conduite d'aspiration (24) peut être reliée de façon pneumatique à une alimentation en air comprimé (9),
- le capteur de pression (26), le capteur d'écoulement (27) et la vanne (25) commandable pouvant être reliés à une électronique de réglage (10),

et un preneur aspirant (15) pour le maintien des composants, une ouverture d'aspiration (16) du preneur aspirant étant reliée de façon pneumatique au branchement d'aspiration (20) du module de réglage de pression (17), et
- une électronique de réglage (10), qui est reliée au capteur d'écoulement (27) et à la vanne (25) commandable, afin de commander la vanne (25) en fonction du débit de gaz dans la conduite d'aspiration (24).

2.  Dispositif selon la revendication 1, sachant que, en ce qui concerne la vanne (25) commandable, il s'agit d'une vanne proportionnelle piézo-électrique.

3.  Dispositif selon l'une quelconque des revendications 1 à 2, la pompe à vide (21) étant une pompe à vide d'écoulement.

4.  Dispositif selon l'une quelconque des revendications 1 à 3, la vanne (25) commandable pouvant être commandée par l'électronique de réglage (10) de telle sorte que le débit de gaz dans la conduite d'aspiration (24) ne dépasse pas un débit maximum.

5.  Dispositif selon l'une quelconque des revendications 1 à 4, l'électronique de réglage (10) réglant dans un mode de réglage de débit le débit de gaz dans la conduite d'aspiration (24) sur une valeur théorique de débit.

6.  Dispositif selon l'une quelconque des revendications 1 à 5, l'électronique de réglage (10) étant reliée au capteur de pression (26), de sorte que l'électronique de réglage (10) règle dans un mode de réglage de pression la pression régnant dans la conduite d'aspiration (24) en fonction du débit de gaz dans la conduite d'aspiration (24).

7.  Dispositif selon l'une quelconque des revendications 1 à 6, l'électronique de réglage (10) reconnaissant en cas de sous-dépassement d'une valeur définie pour le débit de gaz dans la conduite d'aspiration (24) qu'un composant est aspiré sur l'unité de prise (13).

8.  Dispositif selon la revendication 6, l'électronique de réglage (10) pouvant commuter au choix entre le mode de réglage de débit et le mode de réglage de pression.

9.  Procédé de commande pour un dispositif selon l'une quelconque des revendications 1 à 3, l'électronique de réglage (10) activant la vanne (25) commandable lors de l'évacuation par soufflage d'un composant aspiré sur l'unité de prise (13) de telle sorte que le débit de gaz dans la conduite d'aspiration (24) ne dépasse pas un débit maximum.

10. Procédé de commande selon la revendication 9, l'électronique de réglage (10) étant exploitée lors de l'évacuation du composant dans un mode de réglage de débit et réglant le débit de gaz dans la conduite d'aspiration (24) sur une valeur théorique de débit prédéfinie.

11. Procédé de commande selon la revendication 9, l'électronique de réglage (10) étant exploitée dans un mode de réglage de pression lors de l'évacuation du composant et réglant la pression dans la conduite d'aspiration (24) sur une valeur théorique de pression avec laquelle le débit de gaz dans la conduite d'aspiration (24) ne dépasse pas le débit maximum.

12. Procédé de commande selon la revendication 10, l'électronique de réglage (10) pour l'aspiration d'un autre composant étant exploitée dans un mode de réglage de pression après l'évacuation du composant et réglant la pression dans la conduite d'aspiration (24) sur une valeur théorique de dépression prédéfinie.

# FIG 1

# FIG 2

## FIG 3